(19) **Europäisches Patentamt**

**European Patent Office**

**Office européen des brevets**

(11) Veröffentlichungsnummer: **0 209 767**

**A1**

(12) **EUROPÄISCHE PATENTANMELDUNG**

(21) Anmeldenummer: 86109085.0

(22) Anmeldetag: 03.07.86

(51) Int. Cl.⁴: **H01L 21/78** , H01L 21/68

(30) Priorität: 06.07.85 DE 3524301

(43) Veröffentlichungstag der Anmeldung:
28.01.87 Patentblatt 87/05

(84) Benannte Vertragsstaaten:
CH FR GB IT LI

(71) Anmelder: SEMIKRON Elektronik GmbH
Sigmundstrasse 200
D-8500 Nürnberg 82(DE)

(72) Erfinder: Deppe, Johannes
Böhmlach 24
D-8520 Erlangen(DE)
Erfinder: Löwer, Dieter
Franz-Xaver-Schuster-Strasse 25
D-8540 Schwabach(DE)

(54) Verfahren zum Herstellen von Halbleiterelementen.

(57) Ein Verfahren zum Herstellen einer Anzahl von tablettenförmigen Halbleiterkörpern aus einer großflächigen, kontaktierten und auf einer Trägerplatte (10) befestigten Halbleiterausgangsscheibe, bei dem in einigen Schritten eine gleichzeitige Behandlung aller Halbleiterkörper im Verbund und in weiteren Schritten eine Einzelbehandlung erfolgt, wird dadurch optimiert, daß die durch Zerteilen der Ausgangsscheibe erzielten Halbleiterkörper (4) mit Hilfe eines Silikon-Kautschuks (5) mit besonderen Eigenschaften zu einer folienförmigen Struktur verbunden werden, daß an dieser Struktur vor dem Ablösen von der Ausgangsscheibe mittels des Silikon-Kautschuks eine Vorrichtung (13) zum Haltern der Struktur und zum Weiterbearbeiten der darin mechanisch stabil gehalterten Halbleiterkörper angebracht wird, daß die Vorrichtung mit der Struktur von der Trägerplatte abgelöst wird, daß die an der Vorrichtung befestigte Struktur weiteren Verfahrensschritten mindestens bis einschließlich zum Messen unterworfen wird und dann die Halbleiterkörper getrennt werden. Im Rahmen des Zerteilens der Ausgangsscheibe wird an den die Halbleiterkörper bildenden Abschnitten z.B. durch Ätzen oder Sandstrahlen ein definiertes Randprofil erzeugt.

Fig.3

## VERFAHREN ZUM HERSTELLEN VON HALBLEITERELEMENTEN

Die Erfindung betrifft ein Verfahren zum Herstellen von Halbleiterelementen nach den Merkmalen des Anspruchs 1.

Mit diesem bekannten Verfahren ist durch mehrere gezielte Bearbeitungsschritte an einer großflächigen Halbleiterausgangsscheibe eine Anzahl von nachstehend als Halbleiterelemente bezeichneten Halbleiterkörpern kleinerer Flächenausdehnung, z.B. für Halbleiteranordnungen der Leistungselektronik, erheblich rationeller herstellbar als mit früheren Methoden einer vollständigen Einzelbehandlung.

Das Verfahren zeigt jedoch einige Nachteile: Die weiteren Schritte nach dem Ablösen der Halbleiterelemente von der Trägerplatte bis zum Vorliegen gemessener und klassifizierter Elemente erfolgen in Einzelfertigung mit hohem Zeitaufwand. Die Folge und die Durchführung dieser weiteren Verfahrensschritte kann nicht in gewünschter Weise mechanisiert werden, weil besonders die kleinflächigen Halbleiterelemente bei einem zu bevorzugenden Transport als Schüttgut nicht geordnet transportabel sind. Außerdem können bei Behandlung der Halbleiterelemente als Schüttgut Beschädigungen des Halbleitermaterials entstehen, die eine Beeinträchtigung der elektrischen Eigenschaften zur Folge haben.

Die Forderungen der Anwender nach immer kostengünstigeren Halbleiteranordnungen hoher Qualität machen es notwendig, auch die Herstellungsverfahren der Halbleiterelemente immer noch wirtschaftlicher zu gestalten.

Der Erfindung lag die Aufgabe zugrunde, das Verfahren der eingangs genannten Art so zu verbessern, daß nicht nur einzelne, sondern alle zur Erzielung einbaufertiger Halbleiterelemente notwendigen Bearbeitungsschritte jeweils gleichzeitig an allen aus einer Halbleiterausgangsscheibe vorgesehenen Elementen noch im Verbund derselben, das heißt während ihrer gemeinsamen Anordnung auf einer Trägerplatte, durchführbar sind, und daß eine weitgehende Mechanisierung der Bearbeitung der Elemente, eingeschlossen das Messen und Klassifizieren derselben, möglich ist.

Die Aufgabe wird mit den Maßnahmen des kennzeichnenden Teils des Anspruchs 1 gelöst. Vorteilhafte Ausgestaltungen des Verfahrens sind in den Ansprüchen 2 bis 12 angegeben.

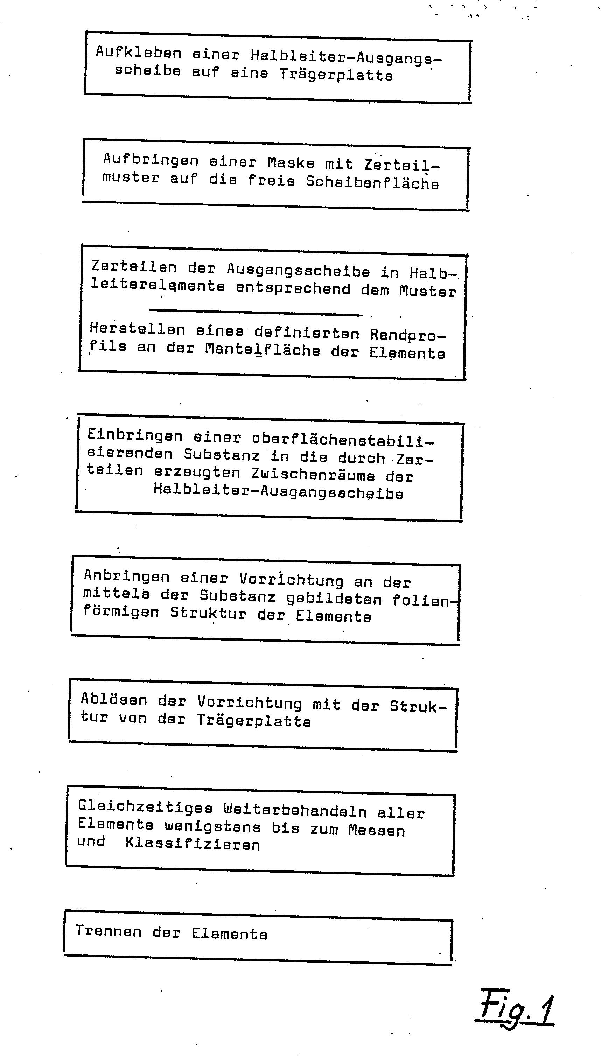

Anhand der Figuren 1 bis 3 wird das Verfahren gemäß der Erfindung erläutert. In Figur 1 ist der Ablauf der Herstellung der Halbleiterelemente - schematisch dargestellt. Die Figuren 2 und 3 zeigen in Draufsicht bzw. im Querschnitt die Ausbildung und Anordnung je einer Vorrichtung als Mittel zur mechanisierten Weiterbehandlung der Halbleiterelemente. Gleiche Teile sind jeweils mit gleichen Bezeichnungen versehen.

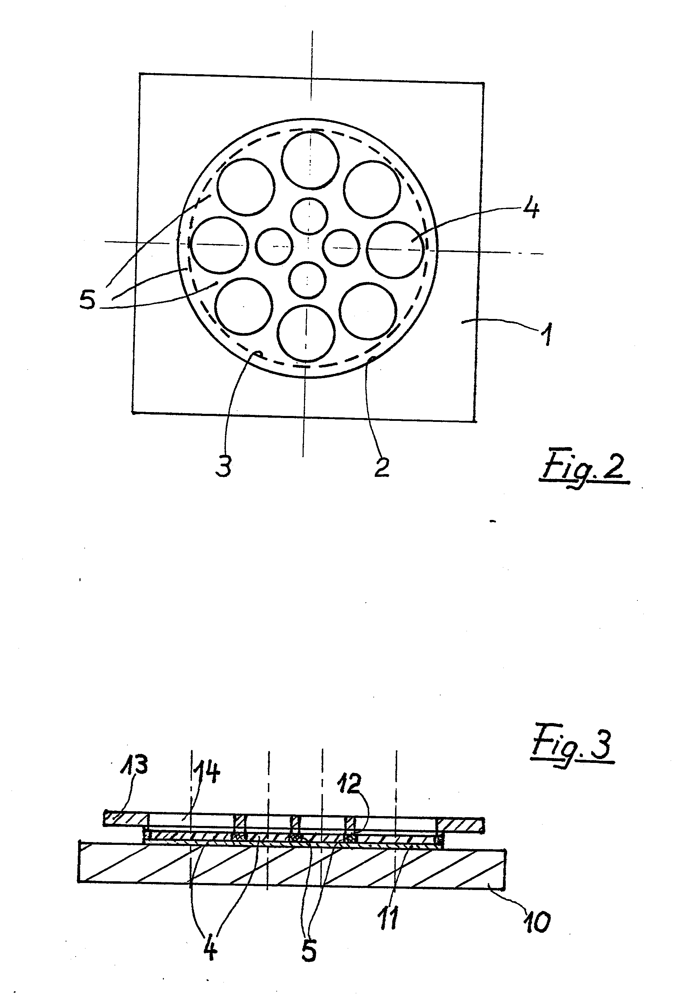

Die zum Herstellen der vorgesehenen und üblicherweise tablettenförmigen Halbleiterelemente erforderliche Ausgangsscheibe3 (vgl. Figur 2) besteht z.B. aus Silizium, weist eine Schichtenfolge mit wenigstens einem pn-Übergang zwischen den beiden Hauptflächen auf und ist an jeder der Hauptflächen mit einem metallischen Überzug als Kontaktelektrode zum Anschluß von Stromleitern versehen.

Eine solche Halbleiterscheibe mit einem Durchmesser von z.B. etwa 100 mm wird auf eine Trägerplatte aufgeklebt, die aus Glas, Kunststoff, Metall oder Keramik oder aus einer Verbindung aus oder mit solchen Materialien bestehen kann. Beispielsweise kann eine Trägerplatte aus Metall mit Kunststoffbesch-ichtung verwendet werden. Zur Befestigung der Halbleiterausgangsscheibe auf der Trägerplatte eignen sich bevorzugt sogenannte Schmelzkleber.

Auf der freien oberen Hauptfläche der Ausgangsscheibe wird durch einen Maskierungsprozeß eine Schicht zum Abdecken von Abschnitten der Scheibe erzeugt, die den späteren tablettenförmigen Halbleiterelementen entsprechen. Die zwischenliegenden, nicht abgedeckten Zonen bilden das Zerteilmuster für die Ausgangsscheibe. Anschließend wird dieser Aufbau z.B einem Ätzprozeß unterworfen, bei welchem die Scheibe längs der freiliegenden, streifenförmigen Zonen in die vorgesehene Anzahl von Halbleiterelementen zerteilt wird.

Erfindungsgemäß wird im Zusammenhang mit dem Zerteilen der Ausgangsscheibe in Halbleiterelemente an den Randzonen der Halbleiterelemente ein definiertes Randprofil hergestellt. Dies kann gleichzeitig mit dem Zerteilen der Ausgangsscheibe oder aber in einem nachfolgenden Ätzprozeß erfolgen. Dabei können Ätzlösungen verwendet werden, welche außerdem gleichzeitig eine abschließende Polierwirkung an den freigelegten Halbleiteroberflächen ergeben.

Das Zerteilen der Ausgangsscheibe und das Ausbilden des Randprofils an den Halbleiterelementen kann auch mittels Sandstrahlen, Sägen oder Ultraschallbohren mit anschließendem Polierätzen der freigelegten Halbleiteroberflächen erfolgen. Beide Verfahrensschritte können nacheinander oder unter bestimmten Voraussetzungen auch gleichzeitig durchgeführt werden.

In die derart erzeugten und bis zur Trägerplatte reichenden Zwischräume zwischen jeweils benachbarten Halbleiterelementen wird nun eine Substanz zur stabilisierenden und passivierenden Abdeckung der zu schützenden Oberflächenbereiche eingebracht. Als solche wird erfindungsgemäß ein Silikon-Kautschuk verwendet, der auf dem Halbleitermaterial gut haftet, von der Unterlage der Halbleiterausgangsscheibe leicht ablösbar ist und - schließlich hohe Temperaturfestigkeit bei Weichlötprozessen aufweist. Die Zweite dieser geforderten Eigenschaften ist dadurch bestimmt, daß die Halbleiterelemente, zur Lösung der gestellten Aufgabe, im Verbund von dem zur Befestigung der Ausgangsscheibe verwendeten Kleber abgelöst werden müssen, sodaß auch der vorgesehene Silikon-Kautschuk vom Kleber lösbar sein muß. Weiter ist die dritte Eigenschaft durch eine Weichlötverbindung der vorgesehenen Halbleiterelemente mit Stromleitern bestimmt, wobei zur Herstellung von Halbleiterelementen nach der Erfindung mit hoher thermischer Stabilität und hoher Lastwechselfestigkeit insbesondere Bleilote mit Zusätzen von z.B. Silber und Zinn verwendet werden.

Es können kalt-oder warmhärtende Kautschuksorten eingesetzt werden. Ein Stoffschutz hierfür wird nicht beansprucht.

Nach dem Aushärten des Kautschuks liegt eine auf der Trägerplatte gebildete Struktur vor, bei welcher die Halbleiterelemente mit Hilfe der zwischenliegenden Kautschukstege gehaltert sind.

Diese im wesentlichen folienförmige Struktur wird nun erfindungsgemäß mit Mitteln zur wenigstens teilweise mechanisierten Weiterbehandlung bis mindestens einschließlich zum Messen und Klassifizieren der Halbleiterelemente verbunden.

Eine besonders vorteilhafte Ausgestaltung des Verfahrens nach der Erfindung besteht darin, daß die Struktur, zum Haltern und Bearbeiten der Halbleiterelemente im Verlauf weiterer Verfahrensschritte, in einer weiterhin als Halterahmen bezeichneten Vorrichtung angeordnet wird. Dieser ermöglicht das Herstellen der Halbleiterelemente in Großserienfertigung, und nach dem Messen und Klassifizieren derselben werden diese längs und innerhalb der Stege aus Silikon-Kautschuk getrennt, vorzugsweise von der Seite mit größerer Zwischenraumbreite aus.

In Figur 2 ist die Anordnung von aus einer Halbleiterausgangsscheibe 3 erzeugten Halbleiterelementen 4 in einem sol chen Halterahmen 1 gemäß der Erfindung dargestellt. Der Halterahmen ist z.B. aus nicht rostendem Stahlblech mit einer Dicke in der Größenordnung der Dicke der Halbleiterausgangsscheibe hergestellt. Er kann auch aus einem Kunststoff bestehen. Die zentrale Öffnung 2 ist durch die Flächenausdehnung der Halbleiterausgangsscheibe bestimmt. Form und Flächenausdehnung des Halterahmens 1 richten sich nach dem Einsatz in den weiteren Verfahrensschritten nach dem Ablösen der Struktur von der Trägerplatte.

Der Halterahmen 1 wird nach dem Zerteilen der Ausgangsscheibe 3 vorzugsweise zentrisch zu dieser -mit unterbrochener Umfangslinie dargestellt -auf die Trägerplatte aufgelegt. Darnach wird in die zwischen den Elementen sowie zwischen den äußeren Elementen der Struktur und dem Halterahmen gebildeten Zwischenräume der Silikon-Kautschuk 5 eingebracht. Aufgrund der geforderten Eigenschaften haftet er an der Innenmantelfläche des Halterahmens 1 und bildet mit den eingeschlossenen Halbleiterelementen 4 die, die Öffnung 2 des Halterahmens 1 ausfüllende folienförmige Struktur 3. Zur Erhöhung der mechanischen Stabilität der aus Halterahmen 1 und Struktur 3 bestehenden Anordnung kann die Dicke des Halterahmens größer gewählt werden.

Für diese Anordnung kann aber auch die üblicherwiese nicht verwertbare Randzone der Halbleiterausgangsscheibe mit verwendet werden. Zu diesem Zweck wird sie beim Zerteilen in die Halbleiterelemente als Kreisring ausgebildet, an deren innere Umfangslinie diejenige der Öffnung 2 des Halterahmens 1 angepaßt ist. Der Halterahmen wird dann auf diesem auf der Träger platte befindlichen Kreisring aus Halbleitermaterial in solcher Lage befestigt, z.B. aufgeklebt, daß beide an ihrer Innenmantelfläche übereinstimmend gestapelt sind. Durch eine solche Kombination von Halterahmen und ringförmigen Rest der Halbleiterausgangsscheibe wird eine vorteilhafte Vergrößerung der Anlagefläche für den Silikon-Kautschuk und damit eine höhere mechanische Festigkeit der gesamten Anordnung erreicht.

Im Falle der Anordnung des Halterahmens 1 auf der Trägerplatte wird der Kleber zum Befestigen der Halbleiterausgangsscheibe 3 vorzugsweise so weit ausgedehnt aufgebracht, daß auch der Halterahmen noch damit befestigt werden kann. Zum Ablösen der Anordnung wird dieselbe zuvor erwärmt und dann in entsprechendem Lösemittel von der Trägerplatte entfernt.

Die Öffnung 2 des Halterahmens 1 kann auch exzentrisch zum Mittelpunkt angebracht sein.

In einer anderen vorteilhaften Ausgestaltung des Verfahrens nach der Erfindung kann zum Haltern und Weiterbearbeiten der Halbleiterelemente in der Struktur eine weiterhin als Halteplatte bezeichnete Vorrichtung verwendet werden. In Figur 3 ist ein Aufbau unter Benutzung einer solchen Halteplatte dargestellt. Auf der Trägeplatte 10 ist mittels eines Klebers 11 eine Halbleiterausgangsscheibe 3 fest aufgebracht, aus welcher durch abtragende Bearbeitung Halbleiterelemente 4 erzielt wurden.

Die zwischenliegenden Abstände sind mit einem Silikon-Kautschuk 5 ausgefüllt. Von der Ausgangsscheibe 3 liegt noch die Randzone vor. Die Halteplatte 13 weist Durchbohrungen 14 auf, deren Anordnung mit derjenigen der Halbleiterelemente 4 übereinstimmt, und deren Form und Ausdehnung derjenigen der Halbleiterelemente zumindest angepaßt ist. Die Halteplatte 13 wird z.B. nach dem Aushärten des Kautschuks 5 mittels eines Klebers 12 auf die Struktur aufgeklebt. Sie kann auch vor Aushärten des Kautschuks aufgelegt werden, wenn die Hafteigenschaft des Kautschuks gegenüber dem Halbleitermaterial auch gegenüber dem Material der Halteplatte wirksam wird. Die Halteplatte 13 wird mit ihren Durchbohrungen 14 zentrisch zu den Halbleiterelementen der Struktur aufgelegt und nach Herstellen einer festen Verbindung mit der Struktur gemeinsam mit dieser von der Trägerplatte abgelöst. Zu der vorgesehenen Weiterbehandlung ist die Halteplatte wenigstens abschnittweise mit einer über diejenige der Struktur hinausragenden Flächenausdehnung ausgebildet, sodaß sie zusammen mit der Struktur leicht abgehoben und anschließend als Tragplatte mit darüber oder darunter haftender Struktur verwendet werden kann.

Die Form der Halteplatte 13 ist durch die weiteren Verfahrensschritte mit den dazu vorhandenen oder vorgesehenen Einrichtungen bestimmt. Die Halteplatte kann weiter Ausbildungen für ihre Fixierung zu mehreren auf einem Transportband aufweisen. Bei ihrer Ausgestaltung kann ferner das lageorientierte Aufsetzen oder Einfügen von Meßkontakten berücksichtigt werden.

Die Halteplatte 13 kann aus Metall oder aus Kunststoff bestehen.

An den mit Hilfe des Halterahmens 1 oder der Halteplatte 13 mechanisch stabil gehalterten Halbleiterelementen 4 können besonders rat-ionell verschiedene Kenngrößenprüfungen durchgeführt werden. So gestatten die in den Figuren 2 und 3 dargestellten Anordnungen jeweils das gleichzeitige Messen einer Kenngröße an allen Elementen in einer entsprechenden Meßeinrichtung. Dazu werden die Halterungsvorrichtungen z.B. mit Bohrungen und/oder Randöffnungen zum Justieren beim Transport oder zum Einlegen in eine Apparatur versehen.

Nach Durchführung aller Bearbeitungsschritte an den im Verbund angeordneten Halbleiterelementen können diese in beliebiger Weise getrennt werden. Besonders vorteilhaft erfolgt das Trennen durch Stanzen oder mittels Laserstrahl.

Das Trennen kann aus die Ausbildung von Elementreihen beschränkt werden, aus welchen bereits klassifizierte Elemente nach dem ermittelten Gütegrad sortiert werden.

Weiter gestattet das Verfahren nach der Erfindung durch gezieltes Trennen eine Aufreihung von Halbleiterelementen als vorbereitende Maßnahme zum mechanisierten Verpacken bzw. Magazinieren derselben für einen späteren Bestückungsvorgang.

## Ansprüche

1. Verfahren zum Herstellen von Halbleiterelementen, bei dem eine großflächige Halbleiterausgangsscheibe, die eine Schichtenfolge mit wenigstens einem pn-Übergang zwischen zwei Hauptflächen aufweist und an jeder Hauptfläche mit einem metallischen Überzug versehen ist, folgenden Verfahrensschritten unterworfen wird:

-Aufkleben auf eine Trägerplatte,

-Aufbringen einer Maske mit Zerteilmuster auf der freien Hauptfläche,

-Zerteilen in Elemente kleinerer Flächenausdehnung,

-Einbringen einer passivierenden und stabilisierenden Substanz in die durch Zerteilen gebildeten Zwischenräume zwischen den Elementen mit gleichzeitigem Abdecken der durch das Zerteilen freigelegten Halbleiter-Oberflächenbereiche der Elemente,

-Ablösen der Elemente von der Trägerplatte,

**dadurch gekennzeichnet,** daß

-mit dem Zerteilen der Scheibe (3) in die Elemente (4) an jedem Element ein definiertes Randprofil erzeugt wird,

-als passivierende und stabilisierende Substanz ein Silikon-Kautschuk (5) verwendet wird, der

-auf dem Halbleitermaterial (3) fest haftet,

-von der Unterlage der Scheibe leicht ablösbar ist und

-für Temperaturen bei Weichlötprozessen mit höher schmelzenden Weichloten geeignet ist,

-die folienförmige Struktur, die aus den dem Zerteilmuster entsprechenden Stegen aus Silikonkautschuk und aus den zwischen diesen Stegen gehalterten Elementen gebildet ist, von der Trägerplatte abgelöst wird,

-an der Struktur Mittel (1, 13) zur wenigstens teilweise mechanisierten Weiterbehandlung der Halbleiterelemente mindestens bis einschließlich zum Messen und Klassifizieren angebracht werden, und

-die Elemente längs und innerhalb der Kautschukstreifen getrennt werden.

2. Verfahren nach Anspruch 1, dadurch gekennzeichnet, daß das Zerteilen der Scheibe und das Erzeugen des Randprofils der Elemente durch Ätzen erfolgt.

3. Verfahren nach Anspruch 1, dadurch gekennzeichnet, daß das Zerteilen der Scheibe und das Erzeugen des Randprofils der Elemente durch Sandstrahlen erfolgt.

4. Verfahren nach Anspruch 1, dadurch gekennzeichnet, daß das Zerteilen der Scheibe und das Erzeugen des Randprofils der Elemente durch Sägen erfolgt.

5. Verfahren nach Anspruch 1, dadurch gekennzeichnet, daß das Zerteilen der Scheibe und das Erzeugen des Randprofils der Elemente durch Ultraschallbohren erfolgt.

6. Verfahren nach Anspruch 1, dadurch gekennzeichnet, daß eine Trägerplatte aus Glas, Keramik, Kunststoff oder Metall oder aus einer Verbindung mit oder aus solchen Materialien verwendet wird.

7. Verfahren nach Anspruch 1, dadurch gekennzeichnet, daß als Mittel zur wenigstens teilweise mechanisierten Weiterbehandlung der Halbleiterelemente (4) ein dieselben umschließender Halterahmen (1) verwendet wird, und daß der Halterahmen, nach dem Zerteilen der Ausgangsscheibe (3), auf der Trägerplatte angeordnet, durch den Silikon-Kautschuk (5) mit den äußeren Halbleiterelementen verbunden und mit der in ihm gehalterten Struktur von der Trägerplatte abgelöst wird.

8. Verfahren nach Anspruch 1, dadurch gekennzeichnet, daß als Mittel zur wenigstens teilweise mechanisierten Weiterbehandlung der Halbleiterelemente eine Halteplatte (13) mit, den Halbleiterelementen (4) nach Fläche und, im Verbund, nach ihrer geometrischen Anordnung entsprechenden Durchbohrungen (14) verwendet wird, und daß die Halteplatte (13) nach dem Ausbilden der Struktur auf dieser, mit zentrischer Zuordnung der Durchbohrungen zu den Halbleiterelementen (4), fest aufgebracht und mit dieser von der Trägerplatte (10) abgelöst wird.

9. Verfahren nach Anspruch 7 oder 8, dadurch gekennzeichnet, daß die Mittel zur Weiterbearbeitung der Halbleiterelemente aus Metall oder aus einem Kunststoff bestehen.

10. Verfahren nach Anspruch 8, dadurch gekennzeichnet, daß die Halteplatte mittels eines Klebers (12) auf der Struktur fest aufgebracht wird.

11. Verfahren nach Anspruch 8, dadurch gekennzeichnet, daß die Halteplatte (13) vor dem Aushärten des Silikon-Kautschuks (5) auf die Struktur aufgelegt und mittels der Haftfähigkeit des Kautschuks mit der Struktur verbunden wird.

12. Verfahren nach einem der vorhergehenden Ansprüche, dadurch gekennzeichnet, daß der Halterahmen und/oder die Halteplatte Mittel zum Justieren der Struktur für deren Weiterbehandlung aufweisen.

> Aufkleben einer Halbleiter-Ausgangs-
> scheibe auf eine Trägerplatte

> Aufbringen einer Maske mit Zerteil-
> muster auf die freie Scheibenfläche

> Zerteilen der Ausgangsscheibe in Halb-
> leiterelemente entsprechend dem Muster
>
> Herstellen eines definierten Randpro-
> fils an der Mantelfläche der Elemente

> Einbringen einer oberflächenstabili-
> sierenden Substanz in die durch Zer-
> teilen erzeugten Zwischenräume der
> Halbleiter-Ausgangsscheibe

> Anbringen einer Vorrichtung an der
> mittels der Substanz gebildeten folien-
> förmigen Struktur der Elemente

> Ablösen der Vorrichtung mit der Struk-
> tur von der Trägerplatte

> Gleichzeitiges Weiterbehandeln aller
> Elemente wenigstens bis zum Messen
> und  Klassifizieren

> Trennen der Elemente

*Fig.1*

*Fig.2*

*Fig.3*

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | CH-A- 557 091 (J. LUCAS LTD.) <br> * Ansprüche 1, 2 * | 1-3,6 | H 01 L 21/78 <br> H 01 L 21/68 |
| Y | DD-A- 112 188 (HADAMOVSKY et al.) <br> * Seite 4, Absätze 3, 4 * | 1-3,6 | |
| A | DE-A-2 731 221 (SEMIKRON) <br> * Ansprüche 1, 5 * | 1,2,5 | |
| A | GB-A-2 129 613 (RAYTHEON) <br> * Seite 3, Zeilen 38-69 * | 1,7-9 | |

---

| | | | RECHERCHIERTE SACHGEBIETE (Int. Cl.4) |
|---|---|---|---|
| | | | H 01 L 21/68 <br> H 01 L 21/78 |

Der vorliegende Recherchenbericht wurde für alle Patentansprüche erstellt.

| Recherchenort | Abschlußdatum der Recherche | Prüfer |
|---|---|---|
| BERLIN | 01-10-1986 | GIBBS C.S. |